# EUROPÄISCHE PATENTSCHRIFT

(11) **EP 1 180 795 B1**
(45) Veröffentlichungstag und Bekanntmachung des Hinweises auf die Patenterteilung: **08.10.2008**
(21) Anmeldenummer: 01118283.9
(22) Anmeldetag: 30.07.2001
(51) Int. Cl.: H01L 21/8242, H01L 21/02, C23C 14/22, H01L 21/28

(54) **Verfahren zum Herstellen einer ersten Elektrode und einer zweiten Elektrode, elektronisches Bauelement und elektronisches Speicherelement**
Method for making a first electrode and a second electrode, electronic component and electronic memory element
Méthode de formation d'une première électrode et d'une seconde électrode, composant électronique et élément de mémoire électronique

(30) Priorität: 09.08.2000 DE 10038894
(43) Veröffentlichungstag der Anmeldung: 20.02.2002
(73) Patentinhaber: Infineon Technologies AG, 81669 München (DE)
(72) Erfinder: Sarstedt, Margit, Dr., 81739 München (DE)
(74) Vertreter: Viering, Jentschura & Partner

(56) Entgegenhaltungen:
- WO-A-99/04434
- US-A- 5 185 287
- US-A- 5 930 625
- US-A- 5 990 493
- PATENT ABSTRACTS OF JAPAN Bd. 1998, Nr. 01, 30. Januar 1998 (1998-01-30) & JP 9 232543 A (NEC CORP), 5. September 1997 (1997-09-05) -& US 6 103 587 A (NAKABEPPU KENICHI) 15. August 2000 (2000-08-15)
- HIHARA T ET AL: "Formation and size control of a Ni cluster by plasma gas condensation" JOURNAL OF APPLIED PHYSICS, AMERICAN INSTITUTE OF PHYSICS. NEW YORK, US, Bd. 84, Nr. 9, 1. November 1998 (1998-11-01), Seiten 5270-5276, XP002139847 ISSN: 0021-8979

## Beschreibung

Die Erfindung betrifft ein Verfahren zum Herstellen einer ersten Elektrode und einer zweiten Elektrode, ein elektronisches Bauelement sowie ein elektronisches Speicherelement.

Für einige Anwendungen im Bereich der Mikroelektronik ist es gewünscht, die Oberfläche von Elektroden, beispielsweise von Silizium-Elektroden oder auch Metall-Elektroden zu vergrößern, um somit eine möglichst große elektrische Kapazität der Elektroden zu erreichen.

Eine Vergrößerung der Elektroden in lateraler Richtung kommt aufgrund der damit verbundenen Vergrößerung des Platzbedarfs einer solchen Elektrode und der damit verbundenen Vergrößerung eines elektronischen Bauelements mit einer Vielzahl solcher Elektroden, oftmals nicht in Frage.

Aus diesem Grund wurde eine Technologie zur Herstellung von Elektroden entwickelt, bei der in einem Substrat Gräben gebildet werden, allgemein Elektrodenanordnungen in dreidimensionalen Strukturen, bei denen die Speicherung der elektrischen Ladungsträger in einer gestapelten Elektrodenanordnung bzw. durch die Verwendung der vertikal verlaufenden in den Gräben angeordneten Elektroden erfolgt.

Bei einer solchen dreidimensionalen Struktur stößt man jedoch sehr schnell auf herstellungstechnische Grenzen, beispielsweise aufgrund der großen Aspektverhältnisse der Gräben, in denen die Elektroden gebildet werden.

Aus diesem Grund wurde versucht, sowohl bei der Verwendung horizontaler als auch vertikal verlaufender kapazitiver Oberflächen, d.h. von Elektroden, die effektiven Elektrodenoberflächen bei gleichbleibenden makroskopischen Dimensionen durch Aufrauhen der jeweiligen Elektrodenoberflächen zu vergrößern.

Zum Aufrauhen einer Elektrodenoberfläche ist es bekannt, beispielsweise mittels eines speziellen Ätzverfahrens zur Vergrößerung der Porosität der Oberfläche oder durch Aufbringen zusätzlicher kugelförmiger Polysilizium-Strukturen auf die Oberfläche der Elektroden, welche auch als Hemispherical Silicon Graines (HSG) bezeichnet wird, vorzusehen.

Bei dem Aufbringen kugelförmiger Polysilizium-Strukturen wird üblicherweise Polysilizium, d.h. polykristallines Silizium, aus einer Lösung auf die aufzurauhende Elektrodenoberfläche aufgewachsen.

Auf der Elektrodenoberfläche entstehen halbkugelförmige Inseln mit einem Durchmesser von üblicherweise ungefähr 30 nm.

Wählt man bei einer Größe von z.B. 30 nm die Dichte dieser Inseln aus Polysilizium derart, dass sie sich in einem gegenseitigen Abstand von ungefähr 30 nm anordnen, dann kann eine Oberflächenvergrößerung von etwas über 20 % erzielt werden.

Nachteilig an dieser Vorgehensweise ist jedoch, dass die Korngröße der einzelnen gebildeten halbkugelförmigen Inseln aus Polysilizium nicht genau kontrollierbar ist und somit nur unter großen prozesstechnischen Problemen und somit hohen Kosten überhaupt eine solche Anordnung erzielt werden kann.

Im weiteren werden die auf einer Elektrodenoberfläche gebildeten halbkugelförmigen Inseln auch als Cluster bezeichnet.

Ferner ist aus [1] eine Cluster-Ionenquelle bekannt, mittels der Nickel-Cluster auf eine Substratoberfläche aufgebracht werden.

Weiterhin ist es aus [2] bekannt, Cluster aus Silber-Atomen auf einem Graphit-Substrat zu bilden.

Weiterhin ist aus [3] eine Vorrichtung zur Massenseparation von Ionen-Clustern, gemäß diesem Beispiel zur Massenseparation von Silber-Clustern, bekannt.

Eine weitere Cluster-Ionenquelle ist in [4] beschrieben.

In [5] ist ein Verfahren beschrieben, bei dem auf eine Elektrode aus Polysilizium Cluster aus Argon oder Phosphor aufgebracht werden.

Somit liegt der Erfindung das Problem zugrunde, ein Verfahren zum Herstellen einer ersten Elektrode und einer zweiten Elektrode sowie ein damit gebildetes elektronisches Bauelement und ein elektronisches Speicherelement anzugeben, bei der eine genauere Einstellung der Korngröße der auf den Oberflächen gebildeten Inseln ermöglicht ist.

Das Problem wird durch das Verfahren zum Herstellen einer ersten Elektrode und einer zweiten Elektrode, das elektronische Bauelement sowie das elektronische Speicherelement mit den Merkmalen gemäß den unabhängigen Patentansprüchen gelöst.

Bei einem Verfahren zum Herstellen einer ersten Elektrode und einer zweiten Elektrode werden die erste Elektrode und die zweite Elektrode aus einem Elektrodenmaterial bereitgestellt, beispielsweise integriert ist in einem Substrat, vorzugsweise in einem Silizium-Substrat.

Mittels einer Cluster-Ionenquelle werden Cluster aus dem Elektrodenmaterial auf die erste Elektrode und/oder zweite Elektrode aufgebracht.

Das Elektrodenmaterial kann sowohl polykristallines Silizium, d.h. Polysilizium, als auch ein grundsätzlich beliebig frei wählbares Metall wie Nickel oder Silber sein.

Durch die Erfindung wird es erstmals möglich, genau vorgebbar ein Strahlprofil zu generieren, so dass am Ort der Deposition, d.h. an der Elektrodenoberfläche einer aufzurauhenden Elektrode eine vorgebare, wenn gewünscht optimierte, Verteilung der zu bildenden Cluster gewährleistet wird.

Weiterhin ist die Größe der zu bildenden Cluster sehr exakt einstellbar.

Ein weiterer Vorteil der Erfindung ist darin zu sehen, dass auf einfache Weise und somit kostengünstig eine sehr genaue Strukturierung der Cluster auf einer Elektrodenoberfläche ermöglicht wird.

Gemäß einer Ausgestaltung der Erfindung kann das Elektrodenmaterial auch dotiertes Silizium sein, d.h. es werden Silizium-Cluster auf einer mit entsprechend gewünschten Dotieratomen dotierten Silizium-Elektroden gebildet, wobei die Dotieratome in einem Kondensationsbereich der Cluster-Ionenquelle dem von der Cluster-Ionenquelle gebildeten Ionenstrahl mit erzeugten Silizium-Ionen hinzugefügt werden, wodurch das Elektrodenmaterial, welches auf der Elektrodenoberfläche als Cluster gebildet wird, dotierte Silizium-Cluster aufweist.

Aus den Elektroden kann grundsätzlich jedes beliebige elektronische Bauelement gebildet werden, welches auf diese Weise gebildete Elektroden enthält.

Ein bevorzugtes Einsatzgebiet einer auf solche Weise gebildeten Elektrode sind elektronische Speicher, beispielsweise ein elektronisches Speicherelement als ein dynamisches Speicherelement mit freiem Zugriff, d.h. ein Random Access Memory (RAM) oder ein Flash-EEPROM.

Die Weiterbildung der Dotierung von erzeugten Ionen-Strahlen in dem Kondensationsbereich der Cluster-Ionenquelle ermöglicht ein sehr exaktes, einfaches und somit kostengünstiges Dotieren des ursprünglich generierten Ionenstrahls zu einem Cluster, welches sowohl die ursprünglich erzeugten Ionen als auch die Dotieratome und somit ein Cluster mit einer vorgebbaren Anzahl von Dotieratomen enthält.

Ein weiterer Vorteil der Erfindung ist darin zu sehen, dass nahezu (halb-)kugelförmige Ionen-Cluster gebildet werden können, so dass potenziell auf diese Weise eine weitere Oberflächenvergrößerung der Elektrodenoberfläche erreicht werden kann.

Weiterhin sind Korngrößen der Cluster durch die Erfindung erzeugbar, die wesentlich kleiner sind als die gemäß dem bekannten Verfahren erzeugbaren Korngrößen der Cluster, so dass auch die an engere Zwischenräume angrenzenden Flächen der Elektrodenoberfläche für eine Oberflächenvergrößerung der Elektrodenoberfläche in Betracht gezogen werden können.

Ausführungsbeispiele der Erfindung sind in den Figuren dargestellt und werden im weiteren näher erläutert.

Es zeigen
- Figur 1: eine Cluster-Ionenquelle zum Erzeugen einer Elektrodenanordnung mit aufgerauhter Elektrodenoberfläche gemäß einem ersten Ausführungsbeispiel der Erfindung;
- Figur 2: einen Querschnitt durch ein elektronisches Bauelement mit zwei Elektroden mit aufgerauhter Elektrodenoberfläche gemäß einem Ausführungsbeispiel der Erfindung; und
- Figur 3: eine Cluster-Ionenquelle gemäß einem zweiten Ausführungsbeispiel der Erfindung zum Erzeugen einer Elektrodenanordnung mit aufgerauhter Elektrodenoberfläche.

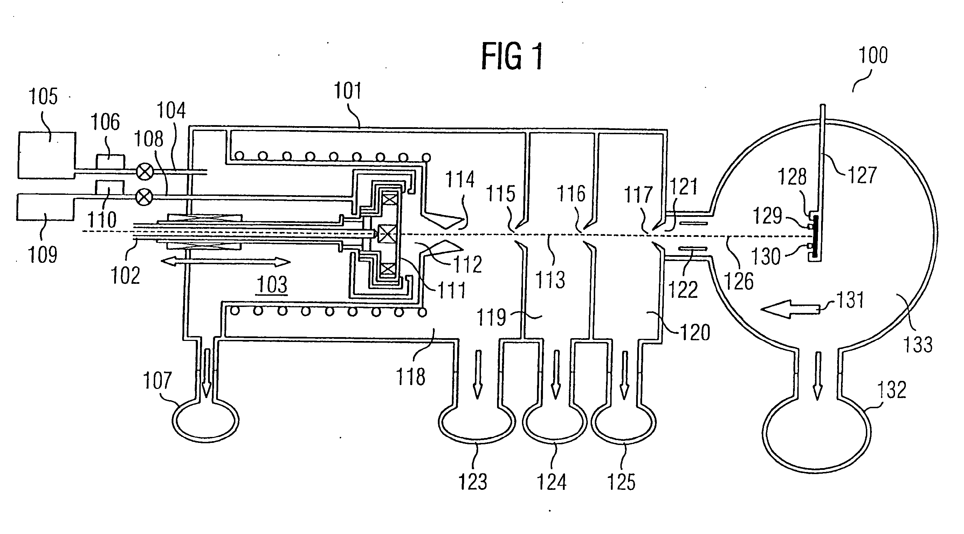

**Fig.1** zeigt eine Cluster-Ionenquelle 100 gemäß einem ersten Ausführungsbeispiel der Erfindung.

Die Cluster-Ionenquelle 100 weist grundsätzlich den gleichen Aufbau auf wie die in [1] beschriebene Cluster-Ionenquelle.

In einem Gehäuse 101 der Cluster-Ionenquelle 100 ist ein Kühlkreislauf 102 vorgesehen, der mit Kühlflüssigkeit, gemäß diesem Ausführungsbeispiel mit Kühlwasser, gefüllt ist.

In dem Gehäuse 101 ist eine Hauptkammer 103 vorgesehen, der über eine erste Zuführleitung 104 Argon in Gasphase aus einem ersten Gasbehälter 105, der mit Argon gefüllt ist, zugeführt wird als kontinuierlicher Gasstrom, der mittels eines ersten Massenfluss-Reglers 106 geregelt wird.

Die Zuführung des Argon-Gases erfolgt unter einem Druck von T_{Si} = 0,1 bis 0,4 kPa, der von einer mit der Hauptkammer 103 verbundenen turbomolekularen Pumpe 107 in der Hauptkammer 103 erzeugt wird.

Weiterhin wird der Hauptkammer 103 über eine zweite Zuführleitung 108 ein Dotiergas, gemäß diesem Ausführungsbeispiel mit Bor-Atomen aus einem zweiten Gasbehälter 109, welches mit dem Dotiergas gefüllt ist, zugeführt als kontinuierlichen oder diskreten Gasstroms, der mittels eines zweiten Massenfluss-Reglers 110 geregelt wird.

Die Argon-Atome werden auf ein Sputter-Target 111 aus Silizium geschossen und durch einen Kondensationsbereich 112 der Cluster-Ionenquelle 100 erfolgt die Zuführung des Dotiergases, so dass ausgehend von dem Sputter-Target 111 ein Ionenstrahl 113 erzeugt wird, der sowohl die Silizium-Ionen als auch die Ionen des Dotiergases enthält.

Der Ionenstrahl wird durch eine Hauptkammer-Öffnung 114 mit einem Durchmesser von ungefähr 5 mm geleitet, wodurch der Ionenstrahl 113 in vorgebbarer Weise geformt wird.

Eine weitere Einstellung des Strahlprofils des gebildeten Ionenstrahls 113 erfolgt durch weitere Öffnungen 115, 116, 117 in weiteren Elektroden deren Öffnungsdurchmesser jeweils ungefähr 5 mm beträgt und die unterschiedliche Wahl der elektrischen Potentiale, die an den Elektroden angelegt werden.

Mittels der Öffnungen 115, 116, 117 ist zwischen den jeweiligen Öffnungen 115, 116, 117 jeweils eine Kammer definiert, nämlich
- ein zwischen der Hauptkammer 103 und der durch die erste Öffnung 115 gebildeter Bereich als eine erste Nebenkammer 118,
- eine zwischen der ersten Öffnung 115 und der zweiten Öffnung 116 gebildete zweite Nebenkammer 119, sowie
- eine dritte Nebenkammer 120 zwischen der zweiten Öffnung 116 und der dritten Öffnung 117.

Im weiteren wird die Funktionsweise der Cluster-Ionenquelle 100 erläutert.

Die freien Argon-Atome werden über die erste Zuführleitung 104 auf das Sputter-Target 111 geschossen und durch den Beschuss auf das Sputter-Target 109 (Silizium-Sputter-Target) werden sogenannte schnelle Silizium-Ionen erzeugt.

Diese freien Silizium-Atome driften durch den Kondensationsbereich 112, indem sie sich unter Hinzufügung des Dotiergases aus Bor-Atomen zu größeren Verbänden, den Ionen-Clustern zusammenschließen.

Die Ionen-Cluster entstehen typischerweise in unterschiedlichsten Größen von nur einigen wenigen bis zu mehreren tausend Atomen, so dass deren Durchmesser kleiner gehalten werden kann als die bekannten Durchmesser von üblicherweise erzeugten Silizium-Inseln, die gemäß dem bekannten Ätzverfahren erzeugt werden können.

Entsprechend der Anzahl der Atome können auf diese Weise Ionen-Cluster mit Größen bis zu einigen Nanometern gebildet werden.

Die Ionen-Cluster werden mittels der Blenden, die die Öffnungen 112, 113, 114, 115 definieren, zu einem scharf begrenzten Ionenstrahl 121 formiert, beschleunigt oder auch verzögert sowie fokussiert.

Durch das elektrische Potential auf den weiteren Elektroden und einem im weiteren erläuterten elektrischen Feld vor dem Target ist es möglich, die Ionen-Cluster mit einer grundsätzlich frei wählbaren Energie auf einer Oberfläche zu deponieren.

Das gewünschte Strahlprofil des Ionenstrahls 113 ist grundsätzlich durch die entsprechende Anordnung der einzelnen Blenden sowie der Wahl der elektrischen Potentiale auf diesen Blenden frei einstellbar.

Der scharf begrenzte Ionenstrahl 121, der noch eine große Anzahl von Ionen-Clustern mit unterschiedlicher Größe und somit unterschiedlicher Masse enthält, wird durch einen Massenseparator 122, d.h. einer Vorrichtung zur Massenseparation, geführt, wie sie in [3] beschrieben ist.

Der jeweilige Druck in den Nebenkammern 118, 119, 120 wird gewährleistet durch weitere turbomolekulare Pumpen 123, 124, 125 die jeweils an die Nebenkammern 118, 119, 120 angeschlossen sind.

Durch die Vorrichtung zur Massenseparation 122 ist es nunmehr möglich, einen Ergebnis-Ionenstrahl 126 zu erzeugen, der die Ionen-Cluster mit der gewünschten Masse und somit der gewünschten Größe und der gewünschten Anzahl von Ionen, d.h. den Silizium-Atomen und den Bor-Dotieratomen, aufweist.

Die Ionen-Cluster werden auf einem in einer Halterung 127 befestigten Substrat 128 auf einer ersten Elektrode 129 sowie einer zweiten Elektrode 130, die beide auf dem Substrat 128 vorgefertigt sind, aufgebracht.

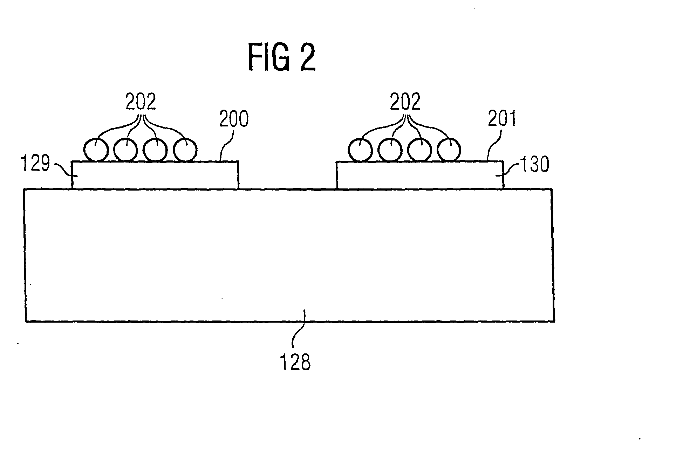

Somit wird, wie in **Fig.2** dargestellt, die Elektrodenoberfläche 200 der ersten Elektrode 129 bzw. die Elektrodenoberfläche 201 der zweiten Elektrode 130 durch die Ionen-Cluster 202 in sehr gut einstellbarer Weise aufgerauht, so dass eine vergrößerte Elektrodenoberfläche 200 der ersten Elektrode 129 und/oder eine vergrößerte Elektrodenoberfläche 201 der zweiten Elektrode 130 erzeugt werden kann.

Um die Elektrodenoberfläche 200, 201 nicht zu zerstören, werden die Ionen-Cluster 202, die auf der ersten Elektrode 129 und/oder der zweiten Elektrode 130 deponiert werden sollen, vor Auftreffen auf die jeweilige Elektrodenoberfläche 200, 201 mittels eines in Gegenrichtung gerichteten elektrischen Feldes, in **Fig.1** symbolisiert durch einen Pfeil 131, abgebremst.

Ferner ist eine weitere turbomolekulare Pumpe 132 vorgesehen, die mit der Depositionskammer 133, in der die Halterung 127 angebacht ist, gekoppelt ist.

Die erforderliche Größe des angelegten elektrischen Feldes ist abhängig von der gewünschten Energie der Ionen-Cluster kurz vor ihrem Auftreffen auf die Elektrodenoberfläche 200, 201 und ist experimentell zu ermitteln.

Nimmt man eine angestrebte Dichte von Ionen-Clustern 202 auf eine Elektrodenoberfläche 200, 201 von ungefähr 10¹⁰ cm⁻² an, so erhält man bei einem angenommenen Strahlstrom von 1 pA eine notwendige Bestrahlungszeit von ungefähr 10 Sek/mm².

Das Strukturieren der Elektrodenoberflächen 200, 201 eignet sich sowohl für Planarelektroden, wie sie in **Fig.2** dargestellt sind, als auch für Elektroden, die in dreidimensionalen Strukturen angeordnet sind, beispielsweise in Gräben vorgebbarer Tiefe.

Für das Deponieren von Ionen-Clustern 202 auf planaren Elektrodenoberflächen 200, 201 ist eine Strahlformierung des Ionenstrahls mit einem möglichst breiten Strahlprofil am Ort der Deposition, d.h. des Auftreffens auf die Elektrodenoberfläche 200, 201 wünschenswert.

Bei dem Deponieren von Ionen-Clustern 202 innerhalb von tiefen Gräben ist ein fokussierter, d.h. sehr scharfer Cluster-Ionenstrahl wünschenswert, der entweder gezielt auf den Ort des jeweiligen Grabens zu richten wäre, an dem das Ionen-Cluster 202 jeweils deponiert werden soll oder über die gesamte Elektrodenoberfläche 200, 201 gerastert werden kann.

Die entsprechende Variabilität des Strahlprofils des Ionenstrahls kann durch geeignete Wahl der ionenoptischen Linsen, die im Strahlweg des Ionenstrahls vorgesehen sind, sowie der an den ionenoptischen Linsen angelegten Spannungen erreicht werden.

Aus den in dem Substrat 128 eingebetteten Elektroden 129, 130 mit aufgerauhter Elektrodenoberfläche 200, 201 können grundsätzlich in weiteren Verfahrensschritten weitere, beliebige elektronische Bauelemente, vorzugsweise DRAM-Speicherelemente sowie Flash-EEPROM-Speicherelemente hergestellt werden.

Als Vorrichtung zur Massenseparation 122 eignet sich gemäß einer alternativen Ausführungsform der Erfindung ein sogenannter Wien-Filter.

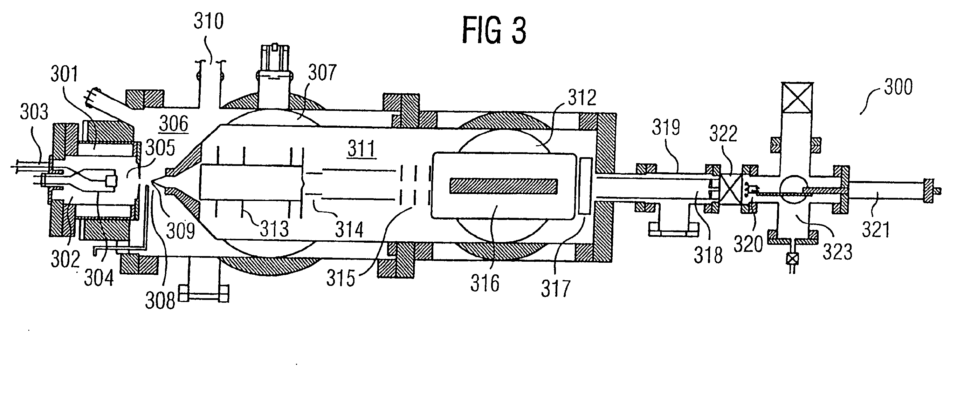

Eine zweite Cluster-Ionenquelle 300 gemäß einem zweiten Ausführungsbeispiel der Erfindung ist in **Fig.3** dargestellt.

Helium-Gas wird mittels einer Zuführleitung 303 in eine mit einem Kühlelement 301 versehene Hauptkammer 302 oberhalb eines Tiegels 304 geführt, der Silizium in der Gasphase enthält. Das Silizium-Gas in dem Tiegel 104 wird durch das Helium gekühlt und kondensiert zu Clustern, die durch eine Hauptöffnung 305 geführt werden.

Die Cluster werden in einen Bereich 306 geführt, der mittels einer Diffusionspumpe 307 auf einem Druck von ungefähr 10⁻⁴ mbar gehalten wird.

Der gebildete Cluster-Strahl wird mit Dotieratomen, gemäß diesem Ausführungsbeispiel mit Bor-Atomen, dotiert mittels einem Kathodenplasma-Erzeuger 308.

Als Dotieratome können alternativ gemäß der Erfindung insbesondere auch die Dotieratome
- Phosphoratome,
- Boratome,
- Arsenatome, aber auch
andere für eine Dotierung geeignete Dotieratome oder weitere Atome, die in ein Cluster eingebracht werden sollen

Der dotierte Cluster-Ionenstrahl 309 wird durch eine Schnabelöffnung 310 zum Fokussieren des Cluster-Ionenstrahls 309 geführt in einen Hochvakuum-Bereich 311, der an eine weitere Diffusionspumpe 312 angeschlossen ist.

Der dotierte Cluster-Ionenstrahl 309 wird in dem Hochvakuum-Bereich 311 beschleunigt und weiter fokussiert in einem Beschleunigungsbereich 313 und ausgerichtet in einem X-Y-Deflektor 314.

Eine Linse 315 fokussiert den dotierten Cluster-Ionenstrahl 309 weiter, und der auf diese Weise fokussierte dotierte Cluster-Ionenstrahl wird einem Wien-Filter 316 als Massenselektor zugeführt.

Mittels eines weiteren Y-Deflektors 317 wird der resultierende Cluster-Ionenstrahl in die Mitte der Massenselektionsöffnung 318 an dem Ende einer Drift-Röhre 319 ausgerichtet.

Die Halterung 320, auf der das Substrat mit den Elektroden aufgebracht ist, wird mittels eines Linearantriebs 321 positioniert.

Ein Ventil 322 ist ferner zwischen der Drift-Röhre 319 und der Depositionskammer 323 vorgesehen zum Steuern des aus dem Wien-Filter 316 und der Drift-Röhre 319 austretenden Cluster-Ionenstrahls.

In diesem Dokument sind folgende Veröffentlichungen zitiert:
[1] T. Hihara und K. Sumiyama, Formationa and size control of a Ni cluster by plasma gas condensation, Journal for Applied Physics, Volume 84, No. 9, S. 5270 - 5275, November 1998
[2] S. G. Hall, M. B. Nielsen und R. E. Palmer, Energetic impact of small Ag clusters on graphite, Journal for applied physics, Volume 83, no 2, S. 733-737, Januar 1998
[3] B. von Issendorff und R. E. Palmer, A new high transmission infinite range mass selector for cluster and nanoparticle beams, Review of Scientific Instruments, Volume 70, No. 12, S. 4497 - 4501, Dezember 1999
[4] I.M. Goldby et al, Gas condensation source for production and deposition of size-selected metal clusters, Rev. Sci. Instrum. 68, (9), S. 3327 - 3334, September 1997
[5] JP 9-232543 A

### Bezugszeichenliste

100 Cluster-Ionenquelle
101 Gehäuse Cluster-Ionenquelle
102 Kühlwasser-Anordnung
103 Hauptkammer
104 Erste Zuführleitung
105 Erster Gasbehälter
106 Erster Massenfluss-Regler
107 Turbomolekulare Pumpe
108 Zweite Zuführleitung
109 Zweiter Gasbehälter
110 Zweiter Massenfluss-Regler
111 Sputter-Target
112 Kondensationsbereich
113 Cluster-Ionenstrahl
114 Hauptkammer-Öffnung
115 Erste Öffnung
116 Zweite Öffnung
117 Dritte Öffnung
118 Erste Nebenkammer
119 Zweite Nebenkammer
120 Dritte Nebenkammer
121 Scharf begrenzter Ionenstrahl
122 Massenseparator
123 Turbomolekulare Pumpe
124 Turbomolekulare Pumpe
125 Turbomolekulare Pumpe
126 Ergebnis-Ionenstrahl
127 Halterung
128 Substrat
129 Erste Elektrode
130 Zweite Elektrode
131 Pfeil
132 Turbomolekulare Pumpe

200 Elektrodenoberfläche erste Elektrode
201 Elektrodenoberfläche zweite Elektrode
202 Ionen-Cluster

300 Cluster-Ionenquelle
301 Kühlelement
302 Hauptkammer
303 Zuführleitung
304 Tiegel
305 Hauptöffnung
306 Bereich
307 Diffusionspumpe
308 Kathodenplasma-Erzeuger
309 Dotierter Cluster-Ionenstrahl
310 Schnabelöffnung
311 Hochvakuum-Bereich
312 Weitere Diffusionspumpe
313 Beschleunigungsbereich
314 X-Y-Deflektor
315 Linse
316 Wien-Filter
317 Weiterer Y-Deflektor
318 Massenselektionsöffnung
319 Drift-Röhre
320 Halterung
321 Linearantrieb
322 Ventil
323 Depositionskammer

## Patentansprüche

1. Verfahren zum Herstellen einer ersten Elektrode und einer zweiten Elektrode,
• bei dem die erste Elektrode und die zweite Elektrode aus einem Elektrodenmaterial bereitgestellt werden,
• **dadurch gekennzeichnet, daß** mittels einer Cluster-Ionenquelle Cluster aus dem Elektrodenmaterial auf die erste Elektrode und/oder die zweite Elektrode aufgebracht werden.

2. Verfahren nach Anspruch 1,
bei dem als Elektrodenmaterial Halbleitermaterial verwendet wird.

3. Verfahren nach Anspruch 2,
bei dem als Elektrodenmaterial Silizium verwendet wird.

4. Verfahren nach einem der Ansprüche 1 bis 3,
bei dem als Elektrodenmaterial mit Dotieratomen dotiertes Silizium verwendet wird.

5. Verfahren nach Anspruch 4,
bei dem die Dotieratome in dem Kondensationsbereich der Cluster-Ionenquelle dem von der Cluster-Ionenquelle gebildeten Ionenstrahl zugefügt wird, wodurch das Elektrodenmaterial bereitgestellt wird.

6. Elektronisches Bauelement mit einer ersten Elektrode und einer zweiten Elektrode,
bei dem die erste Elektrode und/oder die zweite Elektrode gemäß dem Verfahren nach einem der Ansprüche 1 bis 5 gebildet worden ist/sind.

7. Elektronisches Speicherelement mit einer ersten Elektrode und einer zweiten Elektrode,
bei dem die erste Elektrode und/oder die zweite Elektrode gemäß dem Verfahren nach einem der Ansprüche 1 bis 5 gebildet worden ist/sind.

8. Elektronisches Speicherelement nach Anspruch 7,
bei dem das elektronische Speicherelement ein dynamisches Speicherelement mit freiem Zugriff (RAM) ist.

9. Elektronisches Speicherelement nach Anspruch 7,
bei dem das elektronische Speicherelement ein Flash-EEPROM ist.

## Claims

1. Process for producing a first electrode and a second electrode,
• in which the first electrode and the second electrode are provided from an electrode material,
• **characterized in that** a cluster ion source is used to apply clusters of the electrode material to the first electrode and/or the second electrode.

2. Process according to Claim 1,
in which the electrode material used is semiconductor material.

3. Process according to Claim 2,
in which the electrode material used is silicon.

4. Process according to one of Claims 1 to 3,
in which the electrode material used is silicon doped with doping atoms.

5. Process according to Claim 4,
in which the doping atoms are added to the ion beam which is formed by the cluster ion source in the condensation area of the cluster ion source, with the result that the electrode material is provided.

6. Electronic component having a first electrode and a second electrode,
in which the first electrode and/or the second electrode has/have been formed in accordance with the method according to one of Claims 1 to 5.

7. Electronic memory element having a first electrode and a second electrode,
in which the first electrode and/or the second electrode has/have been formed in accordance with the method according to one of Claims 1 to 5.

8. Electronic memory element according to Claim 7,
in which the electronic memory element is a dynamic random access memory (RAM).

9. Electronic memory element according to Claim 7,
in which the electronic memory element is a flash EEPROM.

## Revendications

1. Procédé de production d'une première électrode et d'une deuxième électrode,
• dans lequel on se procure la première électrode et la deuxième électrode en un matériau d'électrode,
**caractérisé en ce que**
• on dépose au moyen d'une source d'ions cluster un cluster en le matériau d'électrode sur la première électrode et/ou sur la deuxième électrode.

2. Procédé suivant la revendication 1,
dans lequel on utilise du matériau semi-conducteur comme matériau d'électrode.

3. Procédé suivant la revendication 2,
dans lequel on utilise du silicium comme matériau d'électrode.

4. Procédé suivant l'une des revendications 1 à 3,
dans lequel on utilise du silicium dopé par des atomes de dopage comme matériau d'électrode.

5. Procédé suivant la revendication 4,
dans lequel on ajoute les atomes de dopage dans la zone de condensation de la source d'ions cluster au faisceau d'ions formé par la source d'ions cluster, en se procurant ainsi le matériau d'électrode.

6. Composant électronique ayant une première électrode et une deuxième électrode,
dans lequel la première électrode et/ou la deuxième électrode est ou sont formée ( s ) par le procédé suivant l'une des revendications 1 à 5.

7. Elément de mémoire électronique ayant une première électrode et une deuxième électrode,
dans lequel la première électrode et/ou la deuxième électrode est ou sont formé ( s ) suivant le procédé selon l'une des revendications 1 à 5.

8. Elément de mémoire électronique suivant la revendication 7,
dans lequel l'élément de mémoire électronique est un élément de mémoire dynamique à accès libre ( RAM ).

9. Elément de mémoire électronique suivant la revendication 7,
dans lequel l'élément de mémoire électronique est une EEPROM flash.
